# EUROPEAN PATENT SPECIFICATION

(11) **EP 3 975 224 B1**
(45) Date of publication and mention of the grant of the patent: **30.11.2022**
(21) Application number: 21183785.1
(22) Date of filing: 05.07.2021
(51) Int. Cl.: H01L 21/268, H01L 21/76, H01L 21/8252, H01L 21/285, H01L 27/06, H01L 29/08, B23K 26/12, H01L 21/335, H01L 21/329, B23K 26/0622, B23K 26/364

(54) **METHOD FOR FABRICATION OF RECESSED ELECTRICAL ELEMENTS**
VERFAHREN ZUR HERSTELLUNG VON VERTIEFTEN ELEKTRISCHEN ELEMENTEN
PROCÉDÉ DE FABRICATION D'ÉLÉMENTS ÉLECTRIQUES ENCASTRÉS

(30) Priority: 29.09.2020 LT 2020553
(43) Date of publication of application: 30.03.2022
(73) Proprietor: Valstybinis Moksliniu Tyrimu Institutas Fiziniu Ir Technologijos Mokslu Centras, 02300 Vilnius (LT); Institute of High Pressure Physics Polish Academy of Sciences, 01-142 Warsaw (PL)
(72) Inventor: KASALYNAS, Irmantas, 10257 Vilnius (LT); INDRISIUNAS, Simonas, 10257 Vilnius (LT); PRYSTAWKO, Pawel, 01-424 Warsaw (PL); KRUSZEWSKI, Piotr, 01-424 Warsaw (PL)
(74) Representative: Draugeliene, Virgina Adolfina

(56) References cited:
- DE-A1-102013 201 298
- US-A1- 2016 225 889
- US-B2- 7 432 142

## Description

### Field of the invention

The invention relates to the field of microelectronic components and is related to the forming of recessed and regrown electrical contacts for wide-bandgap group III nitride semiconductor components by using laser micro-processing with ultrashort laser pulses.

### Background of the invention

The German patent application No. DE102013201298A1, published on July 31, 2014, describes method for the manufacturing of contacts and isolations for *p*/*n-*type GaN light emitting diodes, by using excimer laser irradiation, which has photon energy greater than the bandgap of GaN, to ablate material. In this method laser beam is shaped by projecting it through the mask in order to fabricate multiple recess in the single processing step. However, usage of the beam shaping mask allows the fabrication of only single purpose contacts, which has the same recess depth, during the single laser processing step. Therefore, forming other types of recessed electronic elements in this way requires a new mask, an alignment process and a new processing step for each new element type. Therefore the field of application of the mentioned method is narrow, and forming of several types of electric elements, which can be connected to form a particular electrical circuit to produce a semiconductor electrical device is complex.

The US Patent No. US7432142B2, published on October 7th, 2008, describes a method for manufacturing high-electron-mobility transistor (HEMT) with recessed electrical contacts. The transistor is manufactured by depositing on the substrate group III-N semiconductor buffer and barrier layers, which form a heterojunction in which a high conductivity 2D electron gas region (2DEG) is created. Recessed ohmic and Schottky contacts, which are used to control transistor, are fabricated by coating the barrier layer with a mask, such as an oxide (i.e. SiOₓ) mask or mask made from other material such as AIN or SiₓN_{y}. The mask is patterned using wet chemical etching or dry chemical etching or reactive ion etching or other techniques, removing the mask in the zones where contacts will be fabricated. Recesses for ohmic contacts through the barrier layer to the channel layer, or extending to the channel layer or extending through the channel layer are formed by etching. Recesses could be used in the formation of source and drain electrodes of the transistor. Etching techniques include wet chemical etching, dry chemical etching, reactive ion etching. The structure may be annealed in order to remove or reduce damage to the semiconductor structure caused by etching. The contact layer is grown by such methods as metal organic chemical vapor deposition (MOCVD), molecular beam epitaxy (MBE), plasma-enhanced chemical vapor deposition (PECVD) or other methods. The contact recess is filled with n-type semiconductor, such as highly doped n-type InN, InAIN, AIGaN, AllnGaN, GaN, or other, non-nitride, semiconductor. The highly doped n-type material used in the contact area allows the contact resistance to be reduced. The upper contact material may be a metal or a metal alloy. Ohmic contact can be formed in the contact sites, for example from Ti / Al / Ni / Au layers. The Schottky contact, used as a gate of the HEMT, can be embedded in a recess in a semiconductor layer or formed on top of the semiconductor structure using Ni, Pt, Pd or other materials suitable for Schottky type contact. The mask and residue metal coated on top of the mask can be removed by etching with HF or other etchant.

The US Patent No. US 10388753B1, published on August 20, 2019, describes a method for HEMT fabrication. This method involves the deposition of a protective SiN mask on top of III-N semiconductor heterostructure, consisting of heterojunction and other *in situ* grown supplementary III-N semiconductor layers, the patterning of the protective mask using photomasks and photolithography, the forming the contact recess, reaching to the channel layer, in source and drain regions by using dry etching by inductively coupled plasma reactive ion etching (ICP-RIE) technique using a boron trichloride/chlorine/argon plasma, the regrowth of graded composition AIGaN in the etched recesses using MOCVD technique, the removal of excess materials and mask, and the deposition of metal contact layers. Composition of the regrown AIGaN layer is defined as AlₓGa₁₋ₓN where x decreases during the regrowth process providing gradual decrease of the bandgap.

In the known methods for the fabrication of recessed contacts, described above, contact recess are formed using reactive ion etching, wet chemical etching or plasma etching techniques. Due to the peculiarities of these techniques, in the known methods, described above, the etching of contact recesses is implemented by means of photolithography and photo masks. Using these methods the structure of semiconductor is damaged i.e. by contamination of ancillary materials, employed in the photolithography and etching process steps.

Technical problem to be solved by present invention is to avoid the use of photolithography processes, toxic chemicals, and contamination, damage to the surfaceby reactive ion etching, wet chemical etching, dry chemical etching of recesses.

The invention aims to expand the usage potential of the method for forming of recessed and regrown electric contacts in semiconductor heterostructures by reducing the fabrication time of various recessed electric elements and components and reducing material consumption and simplifying the technology. Furthermore, the proposed method allows to increase the conductivity of recessed and regrown contacts of Group III nitride semiconductor components by forming a contact recess by means of material removal using ultrashort laser pulses in such a way that the damage to the semiconductor structure or contamination with ancillary materials or other damage is reduced in comparison to the other known methods.

### Disclosure of the essence of the invention

The essence of the solution according to proposed invention is that in a method for for fabrication of recessed electrical elements, which by choice can be recessed electrical contacts and/or junctions and/or electrical components, formed in group III-N semiconductor layers heterostructure in which layer composition is selected so, that in a buffer layer of a heterojunction, near boundary with the III-N barrier layer, a two-dimensional electron gas (2DEG) channel is formed, in the regions of the semiconductor layers heterostructure, in which the recessed electrical elements would be formed, recesses are formed and filled with the materials, intended for the forming of selected elements, each recess of the recesses is formed using a laser irradiation and the method comprises the following steps:
a) coating a top surface of the III-N semiconductor layers heterostructure, grown on a substrate, with at least one a protective layer, in order to form a blank,
b) placing the blank, prepared in the step a), into a chamber, vacuumed or filled with an inert or shielding gas, the chamber having a transparent window through which the laser radiation enters the chamber,
c) forming each said recess by directing through the transparent window in the chamber to the blank the focused ultrashort pulsed laser radiation, which has selected parameters to remove the protective layer and required thickness of the material in order to form the recess of required depth in the semiconductor layers of the heterostructure,
d) translating the blank and focused laser beam in respect to each other in the controlled manner to the position, selected for the forming of the next recess, directing the focused laser beam similarly as in the step c) and selecting the appropriate parameters of laser irradiation to form another recess of required shape and depth and/or required number of recesses with the same or different dimensions,
e) filling the recesses, formed in the step c) or d) with corresponding material layers, to form the selected electrical elements,
f) removing the remaining protective layer after forming of required recessed contacts and/or junctions and/or components in the step e),
g) annealing the recessed electrically conductive contacts and junctions and electrical components using the rapid thermal annealing technique to an optimal temperature in the inert gas environment until a metal to 2DEG channel contact resistance is reduced,
h) forming the recessed isolating elements, required for a separation and/or isolation of the elements, formed in the step g) is performed.

The filling of the recesses in the step e) is performed optionally with a III-N semiconductor layer, which has a required doping, and/or a metal compounds, to form a recessed electrically conductive contact and/or a electrically partially conductive contact and/or the junction and/or the electrical component, comprised of the region containing 2DEG channel, and/or the conductive electrical contacts and/or the electrically partially conductive contacts and/or the junctions.

Forming of the isolating elements in step h) comprises the following steps:
- forming the recess separately for each isolating element by directing through the transparent window in the chamber to the blank the focused ultrashort pulsed laser radiation, which has the selected parameters to remove the semiconductor layers of the heterostructure, which form the 2DEG channel,
- translating the blank and focused laser beam in respect to each other in the controlled manner and after translation, directing the focused laser beam to the position, selected for the forming of the next recess, in this way forming the recess of required shape and depth and/or required number of recesses with the same or different dimensions, using properly selected laser irradiation parameters,
- filling the formed recesses with the dielectric material layers, forming nonconductive elements and/or regions.

The ultrashort pulsed laser for the forming of the recesses in the blank has pulse duration between 15 picoseconds and 200 femtoseconds.

The wavelength of the laser irradiation is between 1020 nanometers and 330 nanometers, and the blank is affected with low average power and high pulse repetition rate (0.1-1 MHz) pulsed laser irradiation.

Noble or shielding gas, which are used to fill the chamber, in which recesses are formed, are argon or nitrogen.

The electrical component may be a transistor or a diode, or a resistor or an inductor or a semiconductor device comprising the transistors and/or diodes and/or resistors and/or inductors, interconnected according to the selected circuit.

The formed recessed contacts and isolating regions can be ohmic contacts, Schottky contacts or isolating regions, to each of which the functional properties are assigned during the fabrication by selecting the parameters of laser irradiation and appropriate filler of metal or dielectric.

The each component during the fabrication process is isolated from other components or electrically connected to other components according to the selected circuit.

The remaining protective layer is removed using selective wet chemical etching.

### Advantages of the invention

Proposed method for forming of recessed electrical elements allows to form electrical elements with various functionalities, such as contacts, junctions, electrical components and isolating regions, located between them, without using masks, photomasks and photolithography, and this allows to reduce the fabrication time, reduce materials consumption, and simplify the technology. In the proposed method the separate fabrication step of protective mask patterning and photomask alignment is not needed, because protective mask is patterned in the same fabrication step in which group III-N semiconductor layer heterostructure is micromachined.

In addition, the advantage of the proposed method is that in the forming of contact recesses for the electrical components, using the ultrashort laser pulses for material removal, the damage to the semiconductor heterostructure, contamination with ancillary materials or damage to the surface morphology are lower than when other known techniques are used to form the recesses, including such known techniques as reactive ion etching, wet chemical etching, such as wet chemical etching using potassium hydroxide, dry chemical etching using chlorine plasma or plasma of chlorine compounds. Therefore, when using the proposed method to form recessed conductive contacts, the conductivity between the contact and the semiconductor structure increases without damaging the isolation performance.

In addition, by forming the recess area for the contacts by the proposed method, the shape and the depth of the recess can be varied and/or changed on demand with the same means of micromachining, avoiding use of the photolithography and alignment of the photomasks.

In addition, by forming the recess for the contacts by the proposed method, usage of toxic compounds such as chlorine compounds or other toxic compounds is avoided.

In addition, during the laser micromachining process it is aimed to set the function of each contact, specific to the conductive, semi-conductive or isolating electrical contact.

In addition, it is aimed to produce electrical connections and isolations between the entirety of the semiconductor components according to the given electrical circuit.

### Brief description of the drawings

Fig. 1a - Fig. 1g show a schematic illustration of the fabrication process of the regrown recessed ohmic contact for the III-N semiconductor device, by using laser ablation and laser micromachining, here:
   Fig. 1a shows layers of semiconductor heterostructure;
   Fig. 1b shows semiconductor heterostructure with the mask on top;
   Fig. 1c shows heterostructure with recesses formed of selected shape;
   Fig. 1d shows heterostructure after regrowth of the conductive layer;
   Fig. 1e shows heterostructure after deposition of the metal layer;
   Fig. 1f shows heterostructure after removal of the mask and excess material of metal layer and regrown semiconductor layer;
   Fig. 1g shows heterostructure with regrown ohmic contact;
Fig. 2a - Fig. 2e show a schematic illustration of the fabrication process of the recessed ohmic contact and the recessed Schottky contact for the III-N semiconductor device, by using laser ablation and laser micromachining, here:

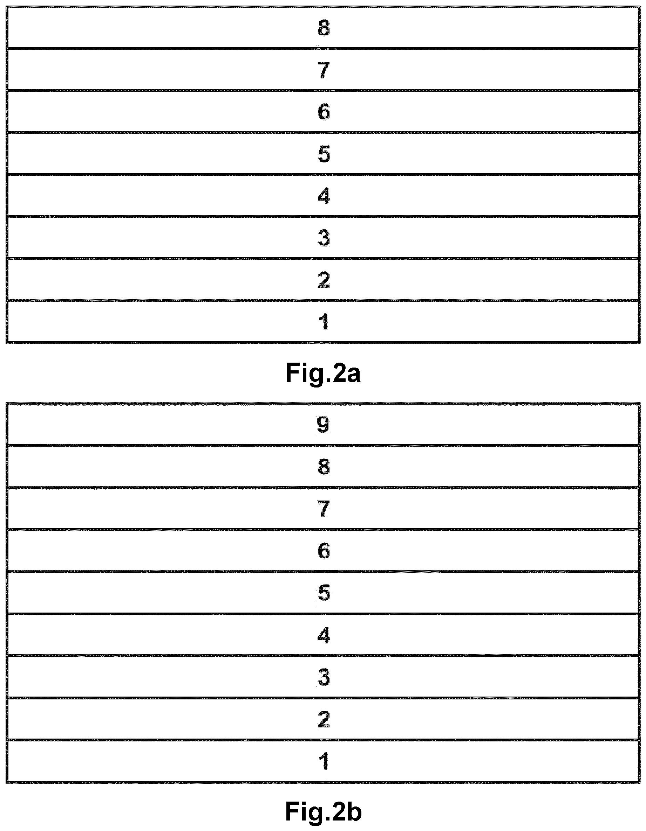

   Fig. 2a shows layers of semiconductor heterostructure;
   Fig. 2b shows semiconductor heterostructure with the mask on top;

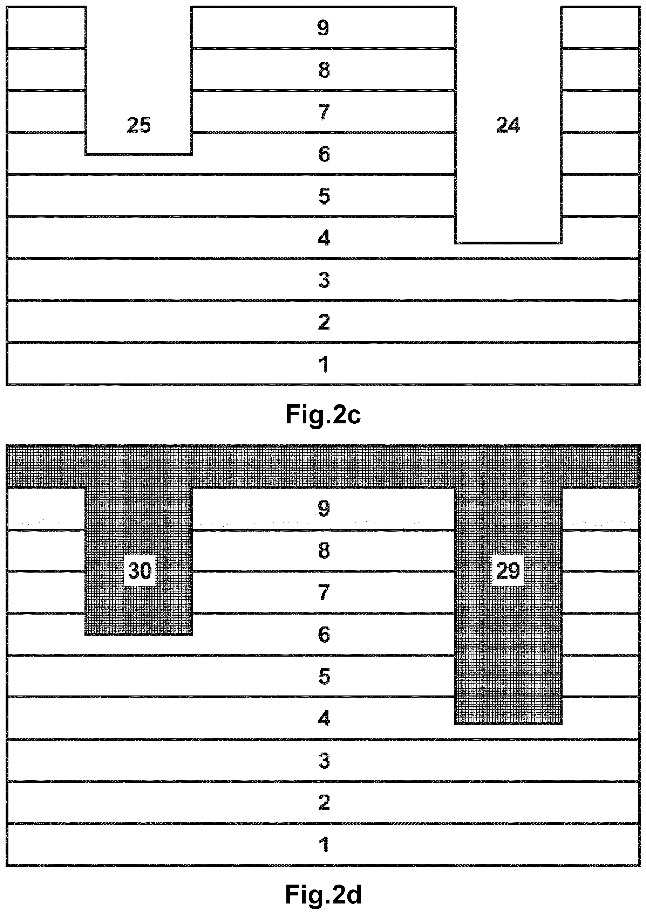

   Fig. 2c shows heterostructure with recesses formed of selected shape;
   Fig. 2d shows heterostructure after deposition of the metal layer filling the recess;

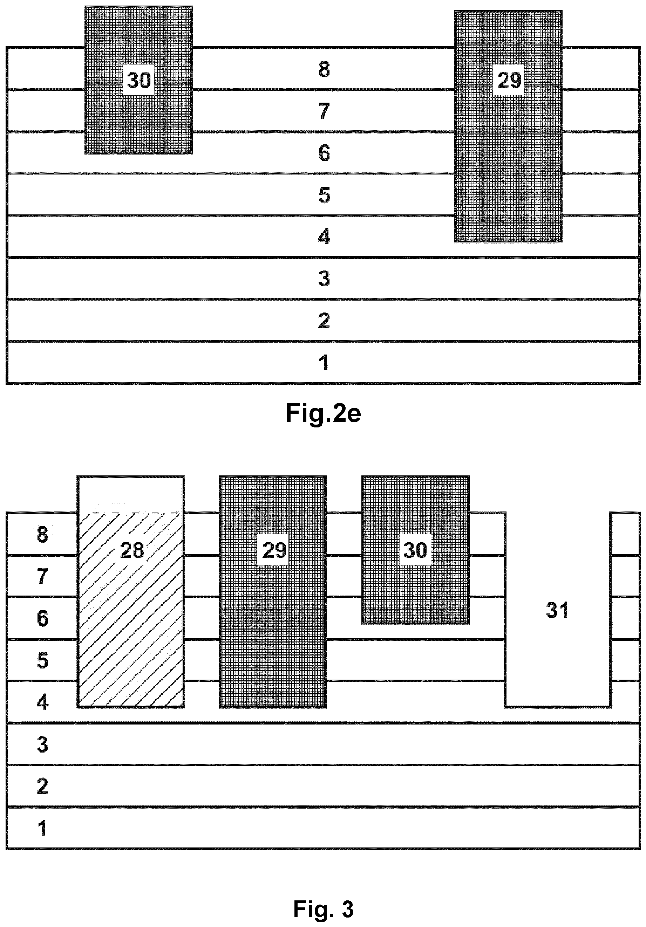

   Fig. 2e shows heterostructure with recessed ohmic and Schottky contacts after removal of the mask and excess material of metal layer;
Fig. 3 shows a schematic illustration of the III-N semiconductor device with two types of ohmic contacts and one of each Schottky contact and isolation contact. The component can be a HEMT transistor, diode, resistor or another microelectronic component;

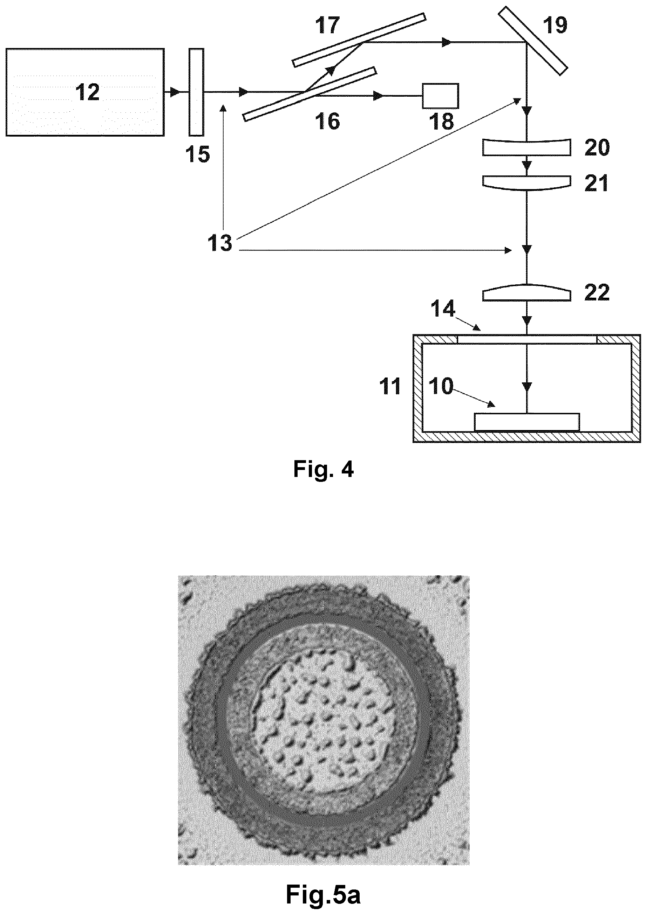

Fig. 4 is a principal scheme of the method for fabrication of the contact recess using laser irradiation;
Fig.5a shows the image of the regrown ohmic contacts fabricated using the proposed method, here the contacts are used to connect to the high conductivity 2DEG channel;

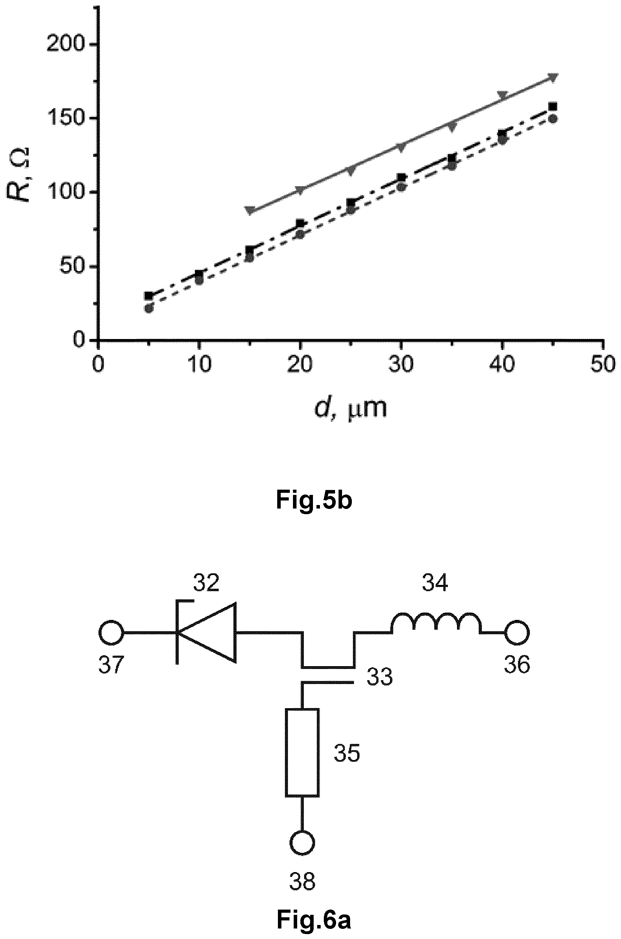

Fig.5b shows TLM characteristics of the ohmic contacts. The TLM graph is a resistance, *R*, measurements versus a distance, *d*, between a pair of contacts, used to connect to a high conductivity 2DEG channel;
Fig. 6a is an illustration, showing the electrical circuit in which diode, transistor, inductor and resistor, formed using the proposed method, are interconnected;

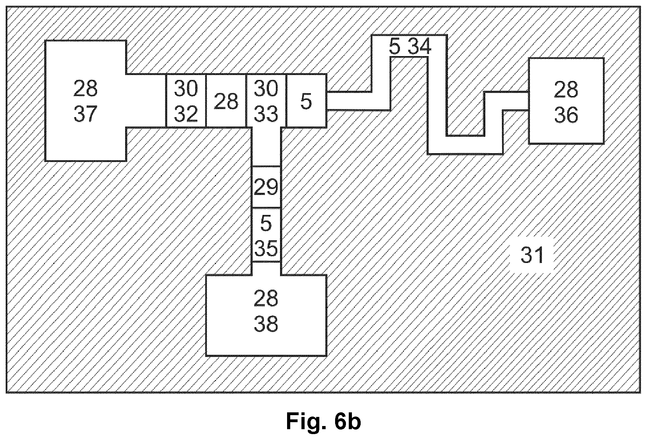

Fig.6b demonstrates the implementation of the electrical circuit, shown in Fig.6a, using regrown and recessed electrical contacts and electrical components, fabricated using the proposed method.

### Detailed description of the invention

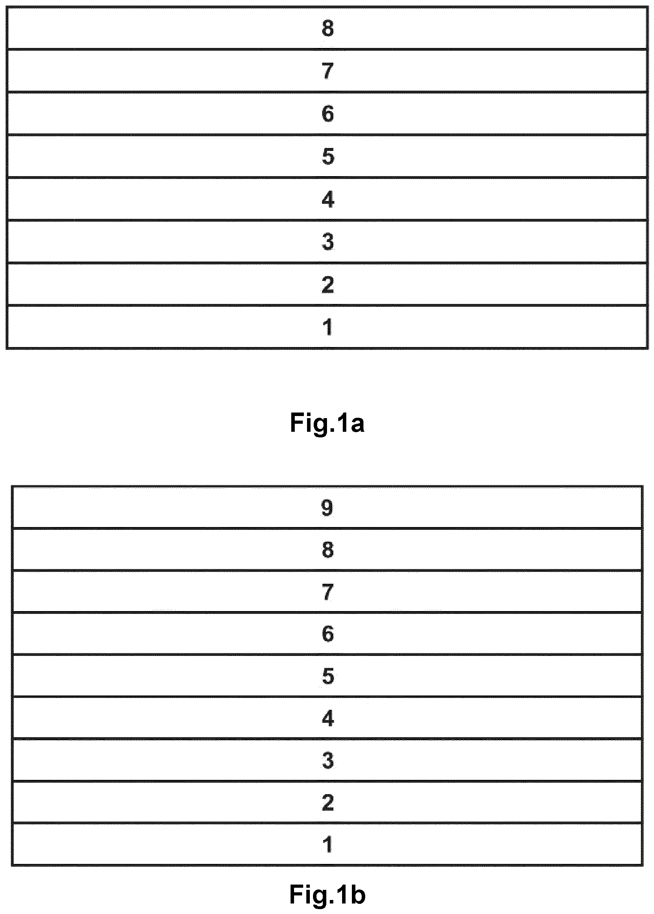

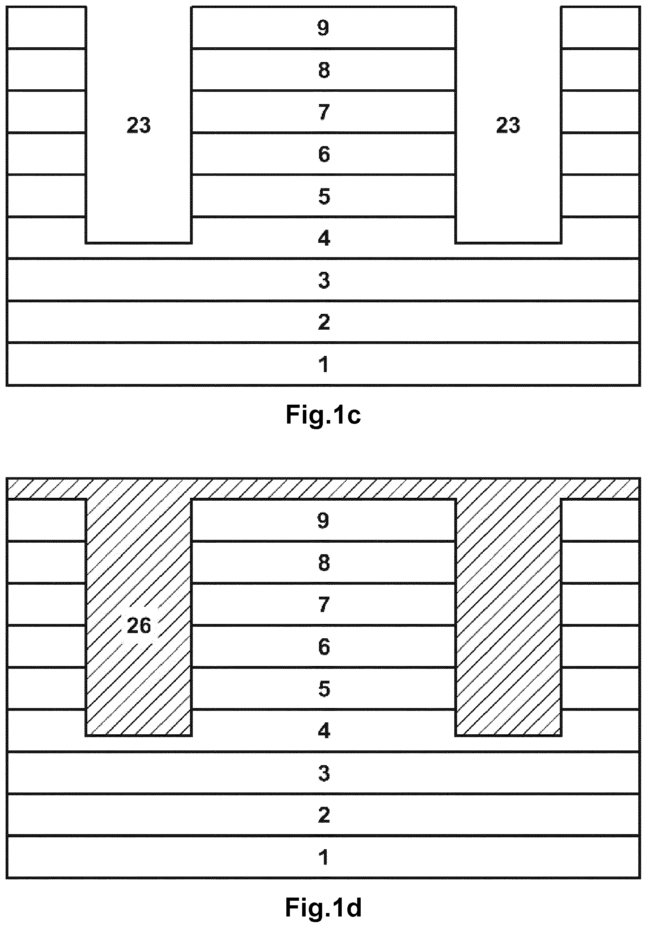

The semiconductor layer heterostructure, shown in Fig. 1a, comprising a substrate 1, a nucleation layer 2, a buffer layer 3, a buffer layer 4, a two-dimensional electron gas (2DEG) region, formed in a top part of the buffer layer and illustrated as a separate layer 5, an optional spacer layer 6, a barrier layer 7, an optional stress-release and a passivation layer 8, is coated with a SiO₂/AlN protective layer 9, shown in Fig. 1b.

The substrate 1 is composed of SiC, sapphire or of other material, suitable for the growth of the III-N semiconductor layers. Nucleation layer 2 is a layer of low-temperature-grown GaN or AIN or other material that provides compensation of lattice mismatch between substrate and the following layers. Buffer layer 3 may be a carbon doped GaN or iron doped GaN. Buffer layer 4 may be unintentionally doped GaN. Optional spacer layer 6 may be composed of AIN or AIGaN with larger Al content in respect to the barrier layer. Barrier layer 7 may be composed of AIGaN or AlInN or AlGaInN. 2DEG channel, labeled as layer 5, is formed in the heterojunction between buffer and barrier layers. Stress-release layer and passivation layer 8 may be composed of GaN, SiN or one or a few layers of other material, grown *in situ* with III-N semiconductor epitaxial layers. The semiconductor layer heterostructure is coated with a protective layer 9, i.e. SiO₂/AlN layer, in order to form a blank 10, shown in Fig. 1b.

The blank 10 is placed in a chamber 11, shown in Fig.4, in which vacuum or a shielding gas atmosphere is formed. The shielding gas, which is employed during the use of laser irradiation, is nitrogen or argon, gas which pressure is one atmosphere or more.

A laser 12 is used for the generation of a directional radiation 13 which is directed to the chamber 11. One wall of the chamber 11 contains a transparent window 14 through which the laser radiation 13 enters the chamber 11. The pulse energy of the laser radiation 13 can be controlled by an attenuator consisting of a half wave phase plate 15 and reflecting thin film Brewster angle polarizers 16 and 17, which may be replaced by another type of polarizer. Unused laser radiation is directed to a optical trap 18. The laser radiation 13 is directed to the chamber using mirrors with dielectric coatings 19. The diameter of the laser beam is controlled by a telescope consisting of a diverging lens 20 and a converging lens 21. Control of the laser beam diameter by telescope is optional. An objective 22 is used to focus the laser beam on the surface of the blank 10.

The transparent window 14 may be made of optical glass, fused quartz or other laser radiation-transparent material. The window 14 can be coated with dielectric coatings that reduce the reflection of laser radiation from the window surfaces.

Laser radiation 13 is pulsed laser radiation with a pulse duration of 15 picoseconds to 200 femtoseconds. The wavelength of laser radiation is in the range from 1020 nanometers to 330 nanometers and laser pulse repetition rate is 0.1-1 MHz.

The principal scheme of the fabrication method of the contact recesses using laser irradiation is shown in Fig. 4.

The chamber 11, containing the blank 10, may be translated relative to the laser beam 13 to form the recess 23, 24, 25 of the desired shape. The recess may be formed to reach to or to and into the buffer layer 4 of undoped GaN or may reach to or into one the above layers, e.g., the barrier layer 7. The depth of the formed recess can be changed on demand for the specific contact and can be selected by changing the energy density of the laser irradiation on the processed surface, the overlap of the spots of the focused laser beam, the number of repetitions. The width of the recess can be varied by selecting the energy density of the laser irradiation on the surface to be processed, the overlap of the spots of the focused laser beam, the number of repetitions of the process, and the method of displacing the chamber 11 with blank 10 relative to the laser beam 13. For example, a channel 500 nanometers deep and 0.01 millimeters wide can be formed using laser irradiation with a wavelength of 515 nanometers, a pulse duration of 300 femtoseconds, and laser radiation is focused so that the energy density of the irradiation at the surface of the semiconductor heterostructure is 0.4 J/cm², the overlap of the focused laser beam spots is 80 percent, the process is repeated 2 times, the process is performed in nitrogen gas environment in pressure of 2 atmospheres.

Fig.1a - Fig.1g shows a schematic illustration of the fabrication process of the regrown ohmic contact.

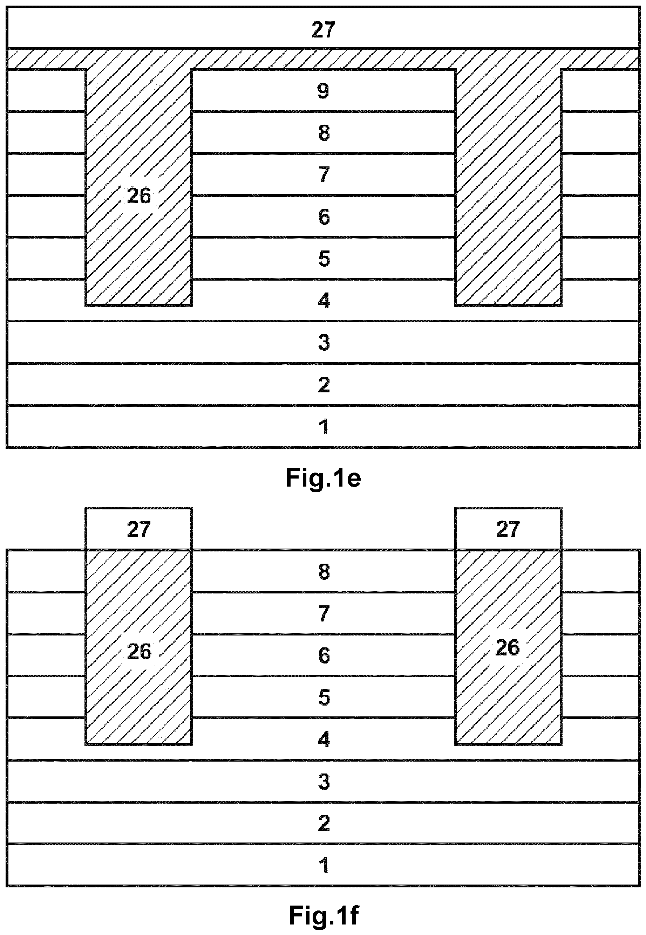

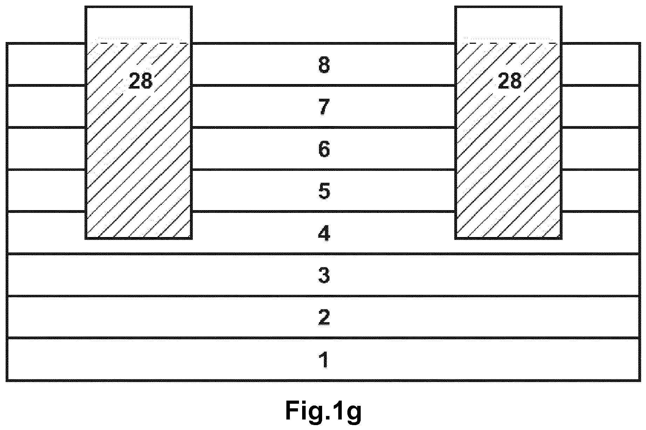

Recess for a regrown ohmic contact 23 is directly formed through the protective layer 9 using laser irradiation 13. The n-type donor doped III-N semiconductor layer 26, such as n-type graded InGaN semiconductor layer, is grown using MOCVD or MOVPE or MBE technique (Fig. 1d), metal layer 27 is deposited on top (Fig. 1e). The excess material of regrown n-type III-N semiconductor layer 26 and excess of metal layer 27 are removed (Fig. 1f) by using the selective wet chemical etching of the SiO₂ mask 9, and forming of the ohmic contact is over (Fig. 1g). Metal layer 27 may contain Ni or Ti layer and may contain additional Au, Al, Ni, Mo layers or layers of other suitable metals on top. The regrown ohmic contact is achieved without thermal annealing or may be annealed as usual for standard ohmic contacts applying rapid thermal annealing technique in the nitrogen environment at temperature lower than 900 °C.

Fig.2a - Fig.2e shows a schematic illustration of the fabrication process of the recessed ohmic contact and the recessed Schottky contact.

The semiconductor heterostructure, shown in Fig. 2a, consisting of the substrate 1, nucleation layer 2, buffer layer 3, buffer layer 4, 2D electron gas channel layer 5, optional spacer layer 6, barrier layer 7 and optional stress-release and passivation layer 8 is coated with a SiO₂/AlN protective layer 9 (Fig.2b).

Recess for a recessed ohmic contact 24 or recessed Schottky contact 25 is directly formed using laser irradiation 13 (Fig.2c). In the laser-formed recess the metal layer is deposited thus forming an ohmic 29 or Schottky 30 contacts (Fig.2d). For the recessed ohmic contact 29, Ni or Ti metal layers are used, additional Au, Al, Ni, Mo or other suitable properties metal layers may be deposited on top. For a recessed Schottky contact 30, Ni or Pd or Pt or Ti or other suitable metals or their alloys are used. SiO₂/AlN mask 9 is removed using selective wet chemical etching (Fig.2e). To increase electrical conductivity of an ohmic contact, the contact may be annealed, for example, by rapid thermal annealing technique in the nitrogen environment at temperature lower than 900 °C.

The formed recessed contacts and isolating elements can be ohmic contacts, Schottky contacts or isolating regions, to each of which the functional characteristics is assigned during the fabrication by selecting parameters of laser irradiation and appropriate metal or dielectric filler. During the fabrication process each component is isolated from other components or (and) electrically connected to other components according to the provided circuit.

Fig. 3 is a schematic illustration of the semiconductor component with regrown ohmic 28, recessed ohmic 29, recessed Schottky 30 contacts and isolation recess 31. The component can be a HEMT resistor, diode, and transistor, in which the high conductivity 2DEG channel 5, formed in the buffer layer 4, close to the boundary with the barrier layer 7, is used. HEMT transistor contains one recessed Schottky contact (Gate electrode G) 30 and two regrown ohmic contacts 28 (one for source electrode S and one for drain electrode D) or one recessed Shottky contact (G) 30 and two recessed ohmic contacts (S, D) 29 or one recessed Schottky contact (G) 30 and two ohmic contacts, one recessed (S or D) 29 and one regrown (D or S) 28. The number and type of contacts in the single component may differ from shown in Fig. 3.

Fig. 5a shows the image of the ohmic contacts, fabricated using the proposed method, and the TLM characteristics of fabricated contacts - dependencies of the resistance on the distance between the contact electrodes (Fig 5b). It demonstrates the resistance, R, dependence on the distance, d, between a pair of contacts, used to connect to a high conductivity 2DEG channel.

Both types of contacts were fabricated on the same chip, however only the laser micro-fabricated contact, processed using the proposed method, has ring-shaped zones, shown in the image in Fig. 5a. In these ring-shaped recess n-type graded InGaN semiconductor was regrown, which in turn was covered by Ti/AI/Ni/Au aloy, which was annealed by rapid thermal annealing technique in the nitrogen environment at 850 °C along with the non-recessed ohmic contacts, formed using the previously known method.

The TLM characteristic of non-recessed ohmic contacts, fabricated using a standard method, is shown by the line fitted on the solid triangle symbols, demonstrating the contact resistance of *R_{c}* = 5.1 Ω×mm. The TLM characteristics for two sets of regrown ohmic contacts, fabricated using the proposed method, are shown by the lines fitted on the solid square and circle symbols, demonstrating the contact resistance of *R_{c}* = 1.8 Ω×mm and *R_{c}* = 1.0 Ω×mm, respectively. The contact resistance of the electrical contacts, fabricated using the proposed method, is 2-5 times lower than that of conventionally manufactured contacts without the recess.

Fig 6a shows electrical circuit diagram according to which diode (32), transistor (33), inductor (34), resistor (35), input contact (36), output contact (37), control contact (38), all formed using the proposed method, are interconnected (Fig. 6b).

## Claims

1. Method for fabrication of recessed electrical elements, which by choice can be recessed electrical contacts and/or junctions and/or electrical components, formed in group III-N semiconductor layers heterostructure in which layer composition is selected so, that in a buffer layer (4) of a heterojunction, near boundary with the III-N barrier layer, a two-dimensional electron gas (2DEG) channel is formed, in the regions of the semiconductor layers heterostructure, in which the recessed electrical elements would be formed, recesses are formed and filled with the materials, intended for the forming of selected elements, wherein each recess of the recesses is formed using a laser irradiation and the method comprises the following steps:
a) coating a top surface of the III-N semiconductor layers heterostructure, grown on a substrate, with at least one a protective layer, in order to form a blank,
b) placing the blank, prepared in the step a), into a chamber, vacuumed or filled with an inert or shielding gas, the chamber having a transparent window through which the laser radiation enters the chamber,
c) forming each said recess by directing through the transparent window in the chamber to the blank the focused ultrashort pulsed laser radiation, which has selected parameters to remove the protective layer and required thickness of the material in order to form the recess of required depth in the semiconductor layers of the heterostructure,
d) translating the blank and focused laser beam in respect to each other in the controlled manner to the position, selected for the forming of the next recess, directing the focused laser beam similarly as in the step c) and selecting the appropriate parameters of laser irradiation to form another recess of required shape and depth and/or required number of recesses with the same or different dimensions,
e) filling the recesses, formed in the step c) or d) with corresponding material layers, to form the selected electrical elements,
f) removing the remaining protective layer after forming of required recessed contacts and/or junctions and/or components in the step e),
g) annealing the recessed electrically conductive contacts and junctions and electrical components using the rapid thermal annealing technique to an optimal temperature in the inert gas environment until a metal to 2DEG channel contact resistance is reduced,
h) forming the recessed isolating elements, required for a separation and/or isolation of the elements, formed in the step g).

2. Method according to claim 1, **characterized in that** the filling of the recesses in the step e) is performed optionally with a III-N semiconductor layer (26), which has a required doping, and/or a metal compounds, to form a recessed electrically conductive contact (28, 29) and/or a electrically partially conductive contact (30) and/or the junction (28, 29, 30) and/or the electrical component (32, 33, 34, 35, 36, 37, 38), comprised of the region containing 2DEG channel (5), and/or the conductive electrical contacts (28, 29) and/or the electrically partially conductive contacts (30) and/or the junctions (28, 29, 30),

3. Method according to claim 1, **characterized in that** forming of the isolating elements in the step h) comprises the following steps:
- forming the recess separately for each isolating element by directing through the transparent window (14) in the chamber (11) to the blank (10) the focused ultrashort pulsed laser radiation (13), which has the selected parameters to remove the semiconductor layers of the heterostructure, which form the 2DEG channel (5),
- translating the blank (10) and focused laser beam (13) in respect to each other in the controlled manner and after translation, directing the focused laser beam (13) to the position, selected for the forming of the next recess, in this way forming the recess (31) of required shape and depth and/or required number of recesses with the same or different dimensions, using properly selected laser irradiation parameters,
- filling the formed recesses with the dielectric material layers, forming nonconductive elements and/or regions.

4. Method according to claim 1 and 3, **characterized in that** the ultrashort pulsed laser (12) for the forming of the recesses in the blank (10) has pulse duration between 15 picoseconds and 200 femtoseconds.

5. Method according to any one of claims 1 to 4, **characterized in that** the wavelength of the laser irradiation is between 1020 nanometers and 330 nanometers, and the blank (10) is affected with low average power and high pulse repetition rate (0.1-1 MHz) pulsed laser irradiation (13).

6. Method according to any one of claims 1 to 5, **characterized in that** noble or shielding gas, which are used to fill the chamber (11), in which recesses are formed, are argon or nitrogen.

7. Method according to any one of claims 1 to 6, **characterized in that** the electrical component may be a transistor (33) or a diode (32), or a resistor (35,) or an inductor (34) or a semiconductor device comprising the transistors and/or diodes and/or resistors and/or inductors, interconnected according to the selected circuit.

8. Method according to any one of claims 1 to 7, **characterized in that** the formed recessed contacts and isolating regions can be ohmic contacts (28, 29), Schottky contacts (30) or isolating regions (31), to each of which the functional properties are assigned during the fabrication by selecting the parameters of laser irradiation (13) and appropriate filler of metal or dielectric.

9. Method according to any one of claims 1 to 8, **characterized in that** the each component during the fabrication process is isolated from other components or electrically connected to other components according to the selected circuit.

10. Method according to any one of claims 1 to 9, **characterized in that** the remaining protective layer (9) is removed using selective wet chemical etching.

## Patentansprüche

1. Verfahren zur Herstellung von vertieften elektrischen Elementen, die wahlweise vertiefte elektrische Kontakte und/oder Übergänge und/oder elektrische Komponenten sein können, die in Gruppe-III-N-Halbleiterschichten als Heterostruktur ausgebildet sind, wobei die Schichtzusammensetzung so ausgewählt wird, dass in einer Pufferschicht (4) eines Heteroübergangs nahe der Grenze zur III-N-Sperrschicht wird ein zweidimensionaler Elektronengaskanal (2DEG) in den Bereichen der Heterostruktur der Halbleiterschichten gebildet, in denen die vertieften elektrischen Elemente gebildet würden, Vertiefungen gebildet und mit den Materialien gefüllt werden, die zum Bilden ausgewählter Elemente bestimmt sind, **dadurch gekennzeichnet, dass** jede Vertiefung der Vertiefungen unter Verwendung einer Laserbestrahlung gebildet wird und das Verfahren die folgenden Schritte umfasst:
a) Beschichten einer oberen Oberfläche der III-N-Halbleiterschichten-Heterostruktur, die auf einem Substrat gewachsen ist, mit mindestens einer Schutzschicht, um einen Rohling zu bilden,
b) Einbringen des in Schritt a) vorbereiteten Rohlings in eine Kammer, vakuumiert oder mit einem Inert- oder Schutzgas gefüllt, wobei die Kammer ein transparentes Fenster aufweist, durch das die Laserstrahlung in die Kammer eintritt,
c) Bilden jeder Vertiefung durch Richten der fokussierten ultrakurz gepulsten Laserstrahlung durch das transparente Fenster in der Kammer auf den Rohling, die ausgewählte Parameter zum Entfernen der Schutzschicht und die erforderliche Dicke des Materials aufweist, um die Vertiefung mit der erforderlichen Tiefe darin zu bilden die Halbleiterschichten der Heterostruktur,
d) Verschieben des Rohlings und des fokussierten Laserstrahls in kontrollierter Weise in Bezug aufeinander zu der Position, die zum Bilden der nächsten Vertiefung ausgewählt ist, Richten des fokussierten Laserstrahls ähnlich wie in Schritt c) und Auswählen der geeigneten Laserparameter Bestrahlung, um eine weitere Vertiefung mit der erforderlichen Form und Tiefe und/oder der erforderlichen Anzahl von Vertiefungen mit denselben oder unterschiedlichen Abmessungen zu bilden,
e) Füllen der in Schritt c) oder d) gebildeten Aussparungen mit entsprechenden Materialschichten, um die ausgewählten elektrischen Elemente zu bilden,
f) Entfernen der verbleibenden Schutzschicht nach dem Bilden von erforderlichen vertieften Kontakten und/oder Übergängen und/oder Komponenten in Schritt e),
g) Tempern der vertieften elektrisch leitenden Kontakte und Übergänge und elektrischen Komponenten unter Verwendung der schnellen thermischen Tempertechnik auf eine optimale Temperatur in der Inertgasumgebung, bis ein Kontaktwiderstand von Metall zu 2DEG-Kanal verringert ist,
h) Bilden der vertieften Isolierelemente, die für eine Trennung und/oder Isolierung der in Schritt g) gebildeten Elemente erforderlich sind.

2. Verfahren nach Anspruch 1, **dadurch gekennzeichnet, dass** das Füllen der Vertiefungen in Schritt e) wahlweise mit einer III-N-Halbleiterschicht (26), die eine erforderliche Dotierung aufweist, und/oder einer Metallverbindung zur Bildung erfolgt einen vertieften elektrisch leitenden Kontakt (28, 29) und/oder einen elektrisch teilweise leitenden Kontakt (30) und/oder die Verbindungsstelle (28, 29, 30) und/oder das elektrische Bauteil (32, 33, 34, 35, 36, 37, 38), bestehend aus dem Bereich, der den 2DEG-Kanal (5) enthält, und/oder den leitenden elektrischen Kontakten (28, 29) und/oder den elektrisch teilweise leitenden Kontakten (30) und/oder den Übergängen (28, 29, 30 ),

3. Verfahren nach Anspruch 1, **dadurch gekennzeichnet, dass** das Bilden der Isolierelemente im Schritt h) folgende Schritte umfasst:
- Ausbilden der Aussparung separat für jedes Isolierelement durch Richten der fokussierten ultrakurz gepulsten Laserstrahlung (13) durch das transparente Fenster (14) in der Kammer (11) auf den Rohling (10), die die ausgewählten Parameter zum Entfernen der Halbleiterschichten aufweist der Heterostruktur, die den 2DEG-Kanal bilden (5),
- kontrolliertes Verschieben des Rohlings (10) und des fokussierten Laserstrahls (13) gegeneinander und nach dem Verschieben Richten des fokussierten Laserstrahls (13) auf die Position, die für die Bildung der nächsten Vertiefung in dieser ausgewählt ist Art und Weise, wie die Vertiefung (31) mit der erforderlichen Form und Tiefe und/oder der erforderlichen Anzahl von Vertiefungen mit den gleichen oder unterschiedlichen Abmessungen gebildet wird, unter Verwendung geeignet ausgewählter Laserbestrahlungsparameter,
- Füllen der gebildeten Vertiefungen mit den dielektrischen Materialschichten, Bilden nichtleitender Elemente und/oder Bereiche.

4. Verfahren nach Anspruch 1 und 3, **dadurch gekennzeichnet, dass** der Ultrakurzpulslaser (12) zum Ausbilden der Vertiefungen im Rohling (10) eine Pulsdauer zwischen 15 Pikosekunden und 200 Femtosekunden aufweist.

5. Verfahren nach einem der Ansprüche 1 bis 4, **dadurch gekennzeichnet, dass** die Wellenlänge der Laserstrahlung zwischen 1020 Nanometer und 330 Nanometer liegt und der Rohling (10) mit geringer mittlerer Leistung und hoher Pulswiederholrate (0,1- 1 MHz) gepulste Laserbestrahlung (13).

6. Verfahren nach einem der Ansprüche 1 bis 5, **dadurch gekennzeichnet, dass** Edel- oder Schutzgase, die zum Füllen der Kammer (11), in der Vertiefungen gebildet werden, verwendet werden, Argon oder Stickstoff sind.

7. Verfahren nach einem der Ansprüche 1 bis 6, **dadurch gekennzeichnet, dass** die elektrische Komponente ein Transistor (33) oder eine Diode (32) oder ein Widerstand (35) oder eine Induktivität (34) oder ein Halbleiterbauelement sein kann umfassend die Transistoren und/oder Dioden und/oder Widerstände und/oder Induktivitäten, die gemäß der ausgewählten Schaltung verschaltet sind.

8. Verfahren nach einem der Ansprüche 1 bis 7, **dadurch gekennzeichnet, dass** die gebildeten vertieften Kontakte und isolierenden Bereiche ohmsche Kontakte (28, 29), Schottky-Kontakte (30) oder isolierende Bereiche (31) sein können, zu denen jeweils die funktionale Eigenschaften werden während der Herstellung zugewiesen, indem die Parameter der Laserbestrahlung (13) und ein geeigneter Füllstoff aus Metall oder Dielektrikum ausgewählt werden.

9. Verfahren nach einem der Ansprüche 1 bis 8, **dadurch gekennzeichnet, dass** jede Komponente während des Herstellungsprozesses gemäß der ausgewählten Schaltung von anderen Komponenten isoliert oder mit anderen Komponenten elektrisch verbunden wird.

10. Verfahren nach einem der Ansprüche 1 bis 9, **dadurch gekennzeichnet, dass** die verbleibende Schutzschicht (9) durch selektives naßchemisches Ätzen entfernt wird.

## Revendications

1. Procédé pour la fabrication d'éléments électriques encastrés, qui peuvent être au choix des contacts électriques encastrés et/ou des jonctions et/ou des composants électriques, formés dans une hétérostructure de couches semi-conductrices du groupe III-N dans laquelle la composition de la couche est choisie de sorte que dans une couche tampon (4) d'une hétérojonction, proche de l'interface avec la couche barrière III-N, un canal de gaz bidimensionnel d'électrons (2DEG) est formé, dans les régions de l'hétérostructure des couches semi-conductrices, dans lesquelles les éléments électriques encastrés seraient formés, des cavités sont formés et remplis des matériaux, destinés à la formation d'éléments sélectionnés, chaque évidement de cavités est formé à l'aide du rayonnement laser et le procédé comprend les étapes suivantes :
a) revêtement de la surface supérieure de l'hétérostructure de couches semiconductrices III-N, déposée sur un substrat, avec au moins une couche de protection, afin de former une ébauche,
b) placer l'ébauche, préparée à l'étape a), dans une chambre, mise sous vide ou remplie d'un gaz inerte ou de protection, la chambre ayant une fenêtre transparente à travers laquelle le rayonnement laser pénètre dans la chambre,
c) former chacune desdits cavité en dirigeant à travers la fenêtre transparente dans la chambre vers l'ébauche le rayonnement ultra-court d'un laser pulsé focalisé, qui a des paramètres sélectionnés pour supprimer la couche protectrice et l'épaisseur requise du matériau afin de former la cavité de profondeur requise dans les couches semiconductrices de l'hétérostructure,
d) translation de l'ébauche et du faisceau laser focalisé l'un par rapport à l'autre de manière contrôlée vers la position sélectionnée pour la formation de la cavité suivante, dirigeant le faisceau focalisé du laser de la même manière qu'à l'étape c) et en choisissant des paramètres appropriés du rayonnement laser pour former une autre cavité de la forme et de la profondeur requise et/ou un nombre requis de cavités de dimensions identiques ou différentes,
e) remplir les cavités, formées à l'étape c) ou d) avec des couches de matériau correspondantes, pour former les éléments électriques sélectionnés,
f) supprimer la couche de protection restante après la formation des contacts et/ou des jonctions et/ou des composants encastrés requis à l'étape e),
g) recuire les contacts et les jonctions électriquement conducteurs et les composants électriques encastrés en utilisant la technique de recuit thermique rapide à une température optimale dans l'environnement de gaz inerte jusqu'à ce qu'une résistance de contact entre le métal et le canal 2DEG soit réduite,
h) former les éléments isolants encastrés, nécessaires à une séparation et/ou isolation des éléments, formés à l'étape g).

2. Procédé selon la revendication 1, **caractérisé en ce que** le remplissage des cavités à l'étape e) est effectué éventuellement avec une couche semi-conductrice III-N (26), qui a un dopage requis, et/ou un composé métallique, pour former un contact électriquement conducteur encastré (28, 29) et/ou un contact électriquement partiellement conducteur (30) et/ou la jonction (28, 29, 30) et/ou le composant électrique (32, 33, 34, 35, 36, 37, 38), composé de la région contenant le canal 2DEG (5), et/ou les contacts électriques conducteurs (28, 29) et/ou les contacts électriquement partiellement conducteurs (30) et/ou les jonctions (28, 29, 30 ),

3. Procédé selon la revendication 1, **caractérisé en ce que** la formation des éléments isolants à l'étape h) comprend les étapes suivantes :
- former la cavité séparément pour chaque élément isolant en dirigeant à travers la fenêtre transparente (14) dans la chambre (11) vers l'ébauche (10) le rayonnement ultra-court d'un laser pulsé focalisé (13), qui a les paramètres sélectionnés pour éliminer les couches semi-conductrices de l'hétérostructure, qui forment le canal 2DEG (5),
- translater l'ébauche (10) et le faisceau laser focalisé (13) l'un par rapport à l'autre de manière contrôlée et après translation, diriger le faisceau laser focalisé (13) vers la position, sélectionnée pour la formation de l'évidement suivant, dans ce manière à former l'évidement (31) de la forme et de la profondeur requises et/ou du nombre requis d'évidements avec des dimensions identiques ou différentes, en utilisant des paramètres d'irradiation laser correctement sélectionnés,
- remplir les cavités formées avec les couches de matériau diélectrique, formant des éléments et/ou des régions non conductrices.

4. Procédé selon la revendication 1 et 3, **caractérisé en ce que** le laser pulsé de rayonnement ultracourt (12) pour la formation des cavités dans l'ébauche (10) a une durée d'impulsion comprise entre 15 picosecondes et 200 femtosecondes.

5. Procédé selon l'une quelconque des revendications 1 à 4, **caractérisé en ce que** la longueur d'onde du rayonnement laser est comprise entre 1020 nanomètres et 330 nanomètres, et l'ébauche (10) est affectée d'une faible puissance moyenne et d'un taux de répétition des impulsions élevé (0,1- 1 MHz) du rayonnement de laser pulsé (13).

6. Procédé selon l'une quelconque des revendications 1 à 5, **caractérisé en ce que** les gaz nobles ou de protection, qui sont utilisés pour remplir la chambre (11), dans laquelle des cavités sont formées, sont de l'argon ou de l'azote.

7. Procédé selon l'une quelconque des revendications 1 à 6, **caractérisé en ce que** le composant électrique peut être un transistor (33) ou une diode (32), ou une résistance (35,) ou une inductance (34) ou un dispositif semi-conducteur comprenant les transistors et/ou diodes et/ou résistances et/ou inductances, interconnectés selon le circuit choisi.

8. Procédé selon l'une quelconque des revendications 1 à 7, **caractérisé en ce que** les contacts encastrés et les régions d'isolement formés peuvent être des contacts ohmiques (28, 29), des contacts Schottky (30) ou des régions d'isolement (31), à chacun desquels les propriétés fonctionnelles sont attribuées lors de la fabrication en sélectionnant les paramètres de rayonnement du laser (13) et la charge d'un métal ou d'un diélectrique approprié.

9. Procédé selon l'une quelconque des revendications 1 à 8, **caractérisé en ce que** chaque composant lors du processus de fabrication est isolé des autres composants ou relié électriquement aux autres composants selon le circuit choisi.

10. Procédé selon l'une quelconque des revendications 1 à 9, **caractérisé en ce que** la couche de protection restante (9) est supprimée par gravure chimique humide sélective.
